# EUROPÄISCHE PATENTANMELDUNG

(11) **EP 0 945 905 A2**
(43) Veröffentlichungstag der Anmeldung: **29.09.1999**
(21) Anmeldenummer: 99105957.7
(22) Anmeldetag: 24.03.1999
(51) Int. Cl.: H01L 29/78, H01L 29/10

(54) **FET-Kanalstruktur**

(30) Priorität: 24.03.1998 DE 19812945
(71) Anmelder: SIEMENS AKTIENGESELLSCHAFT, 80333 München (DE)
(72) Erfinder: Eisele, Ignaz Prof., 82057 Icking (DE)

(57) **Zusammenfassung**

Die vorliegende Erfindung schafft ein Halbleiterbauelement mit einem Kanalgebiet (40), das mit einem Dotierstoff dotiert ist, das einen ersten Leitungstyp aufweist und das sich zwischen einem ersten Dotierungsgebiet (20) und einem vom ersten Dotierungsgebiet (20) beabstandeten zweiten Dotierungsgebiet (30) erstreckt, wobei das erste und zweite Dotierungsgebiet (20, 30) einen zweiten Leitungstyp aufweisen, und mit einer am Kanalgebiet (40) vorgesehenen und gegenüber diesem isolierten Elektrode (60). Das Halbleiterbauelement ist dadurch gekennzeichnet, daß das Kanalgebiet (40) entlang seiner Erstreckung zwischen dem ersten und zweiten Dotierungsgebiet (20, 30) zumindest zwei Abschnitte (50, 55) mit unterschiedlich hoher Nettokonzentration des Dotiermittels aufweist.

## Beschreibung

Die vorliegende Erfindung liegt auf dem Gebiet der Halbleitertechnik und betrifft ein Halbleiterbauelement mit einem Kanalgebiet, das mit einem Dotierstoff dotiert ist, das einen ersten Leitungstyp aufweist und das sich zwischen einem ersten Dotierungsgebiet und einem vom ersten Dotierungsgebiet beabstandeten zweiten Dotierungsgebiet erstreckt, wobei das erste und zweite Dotierungsgebiet einen zweiten Leitungstyp aufweisen, und mit einer am Kanalgebiet vorgesehenen und gegenüber diesem isolierten Elektrode, und betrifft weiterhin Verfahren zur Herstellung des Halbleiterbauelements.

Unter einem Dotierungsgebiet soll im folgenden ein Gebiet in einem Halbleitersubstrat verstanden werden, in das ein Dotierstoff eingebracht wurde. Bei Verwendung eines Elektronendonators als Dotierstoff ist das Dotierungsgebiet n-leitend; bei Verwendung eines Elektronenakzeptor ist das Dotierungsgebiet entsprechend p-leitend. Das Dotierungsgebiet weist daher je nach der Konzentration der Elektronendonatoren bzw. Elektronenakzeptoren einen bestimmten Leitungstyp auf. Mit Nettokonzentration ist der Differenzbetrag zwischen der Konzentration der Elektronendonatoren und der Konzentration der Elektronenakzeptoren gemeint, d. h. die effektiv wirkende Überschußkonzentration der Dotierstoffe.

Obwohl prinzipiell auf beliebige derartige Halbleiterbauelemente anwendbar, werden die vorliegende Erfindung sowie die ihr zugrundeliegende Problematik in bezug auf sogenannte MOSFET's (Metall-Oxid-Silizium-Feldeffekttransistor) erläutert.

Der prinzipielle Aufbau eines eingangs genannten Halbleiterbauelements in MOSFET-Ausführung ist beispielsweise in S. M. Sze: 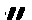 Physics of Semiconductor Devices", S. 433 - 434, John Wiley & Sons, 2. Auflage (1981) beschrieben. Ein p-leitendes Kanalgebiet erstreckt sich dort in einem p-dotierten Substrat zwischen zwei n-leitenden Dotierungsgebieten, wobei ein Dotierungsgebiet mit Source, das andere mit Drain bezeichnet wird. Eine das gesamte Kanalgebiet überdeckende Elektrode ist unter Zwischenlage eines elektrisch isolierenden Oxids auf dem Substrat angeordnet. Unter Beaufschlagen der Elektrode mit einer Spannung, die oberhalb einer gewissen Einsatzspannung U_{T} liegt, kann nachfolgend ein durch das Kanalgebiet fließender elektrischer Strom zwischen Drain und Source beeinflußt werden.

Zum fehlerfreien und dauerhaften Betrieb von MOSFET's und insbesondere von Kurzkanal-MOSFET's, bei denen u. a. die Kanalgröße zum Erreichen einer hohen Integrationsdichte von Halbleiterbauelementen auf einem Substrat stark verkleinert ist, muß eine Reihe von Anforderungen an das Kanalgebiet gelöst werden.

Um beispielsweise die Spannungsfestigkeit zu verbessern bzw. den Lawinendurchbruch zu verhindern, werden bisher LDD(Lightly Doped Drain = leicht dotierter Drain)-Gebiete vorgesehen, die eine zum Kanalgebiet entgegengesetzte, zum Drain und Sourcegebiet jedoch gleiche, Dotierung aufweisen und das Kanalgebiet zum Drain- und/oder Sourcegebiet begrenzen. Bei Leistungstransistoren wird ein schwach dotiertes n⁻-Gebiet vor dem n⁺-Drain vorgesehen. Eine weitere Möglichkeit besteht im Einbau asymmetrischer n⁻-Gebiete in den Kanal bei p-Kanal-Leistungstransistoren.

Es gibt neben der Spannungsfestigkeit aber noch weitere Parameter, die bei derartigen MOSFET's optimiert werden müssen. Diesbezügliche Anforderungen an die Kanaleigenschaften für Kurzkanal-MOSFET's sind nachstehend aufgelistet.

| | |
|---|---|
| Einstellen einer geometrie-unabhängigen Einsatzspannung und kleiner Drain-Steilheit | Hohe Dotierung |
| Vermeiden von Lawinendurchbruch (Spannungsfestigkeit) | Niedrige Dotierung |
| Kleine Subthreshold-Steilheit (60-70 mV/Dek) | Niedrige Dotierung |
| Hohe Gate-Steilheit (hohe Beweglichkeit) | Niedrige Dotierung |
| Vermeidung des Drain Induced Barrier Lowering (DIBL) | Hohe Dotierung |
| Vermeidung von Punchthrough | Hohe Dotierung |

Offensichtlich sind diese verschiedenen Anforderungen bisher noch nicht in ausreichendem Maße gleichzeitig erfüllbar.

Daher ist es Aufgabe der vorliegenden Erfindung, ein Halbleiterbauelement zu schaffen, das diese Anforderungen besser erfüllt.

Erfindungsgemäß wird diese Aufgabe durch ein eingangs genanntes Halbleiterbauelement dadurch gelöst, daß das Kanalgebiet entlang seiner Erstreckung zwischen dem ersten und zweiten Dotierungsgebiet zumindest zwei Abschnitte mit unterschiedlich hoher Nettokonzentration des Dotierstoffs aufweist.

Die der vorliegenden Erfindung zugrundeliegende Idee besteht darin, daß das Kanalgebiet entlang seiner Erstreckung zwischen dem ersten und dem zweiten Dotierungsgebiet ein inhomogenes Dotierungsprofil aufweist.

Durch die in das Kanalgebiet eingebrachten Abschnitte mit unterschiedlich hoher Nettokonzentration des Dotierstoffs können die Kanaleigenschaften verändert und den oben genannten Anforderungen gezielt angepaßt werden. So läßt sich beispielsweise die Einsatzspannung U_{T} durch Wahl eines hochdotierten Abschnitts einstellen. Unabhängig davon ist durch einen weiteren Abschnitt mit niedrigerer Dotierung eine hohe Spannungsfestigkeit gewährleistet.

Die jeweiligen Abschnitte des Kanalgebiets schließen dabei Randgebiete zu angrenzenden Abschnitten oder Dotierungsgebieten ein. Diese Randgebiete stellen Übergangszonen zu der in den angrenzenden Dotierungsgebieten oder Abschnitten herrschenden Nettokonzentration dar und werden im Sinne der Erfindung nicht als separate Abschnitte betrachtet.

Die Nettokonzentration des Dotierstoffs im gesamten Kanalgebiet kann erfindungsgemäß abschnittsweise den Anforderungen an die Kanaleigenschaften angepaßt werden, wodurch ein inhomogenes Dotierprofil des Kanalgebiets mit unterschiedlich hoher Nettokonzentration des Dotierstoffs entsteht. Hierdurch lassen sich die einzelnen Kanaleigenschaften unabhängig voneinander verändern.

Das erfindungsgemäße Halbleiterbauelement weist somit gegenüber den bekannten Lösungsansätzen u.a. folgende Vorteile auf:
- Minimierung des Rₒₙ durch Reduzierung der Kanallänge
- Steigerung der Durchbruchsfestigkeit durch Reduzierung des elektrischen Feldes (Abschnitte mit geringer Dotierung)
- Verringerung des Kanalwiderstandes durch Erhöhung der Be-weglichkeit (Abschnitte mit geringer Dotierung)
- Unabhängige Variationen von Rₒₙ und der Einsatzspannung U_{T} (jeweils durch Abschnitte mit geringer bzw. hoher Dotierung).

Eine vorteilhafte Ausführungsform der Erfindung ist dadurch gekennzeichnet, daß das Kanalgebiet entlang seiner Erstreckung zwischen dem ersten und zweiten Dotierungsgebiet einen schwach dotierten ersten Abschnitt mit einer geringen Leitfähigkeit und einen gegenüber diesem stärker dotierten zweiten Abschnitt mit einer hohen Leitfähigkeit aufweist.

Bevorzugt weist das Kanalgebiet einen schwach dotierten ersten Abschnitt auf, der beispielsweise durch ein schwachdotiertes Substrat gebildet sein kann. Ein gegenüber dem ersten Abschnitt stärker dotierter zweiter Abschnitt des Kanalgebiets ist beispielsweise dem ersten Dotierungsgebiet vorgelagert. In der Erstreckung des Kanalgebiets zwischen dem ersten und dem zweiten Dotierungsgebiet schließt sich somit zunächst der zweite und stärker dotierte Abschnitt des Kanalgebiets an das erste Dotierungsgebiet an, gefolgt von dem ersten und schwächer dotierten Abschnitt des Kanalgebiets. An diesen ersten Abschnitt des Kanalgebiets grenzt schließlich das zweite Dotierungsgebiet an. Die beiden Abschnitte des Kanalgebiets sind vorzugsweise mit dem gleichen Dotierstoff jedoch in unterschiedlich hoher Konzentration dotiert. Die beiden Abschnitte können aber auch jeweils mit unterschiedlichen Dotierstoffen, bzw. mit einem Gemisch von Dotierstoffen, dotiert sein. Wesentlich dabei ist, daß die Abschnitte den ersten Leitungstyp aufweisen.

Die unterschiedlich hohe Nettokonzentration bewirkt eine unterschiedlich hohe Ladungsträgerdichte und somit eine veränderte Leitfähigkeit der einzelnen Abschnitte, wodurch sich die Kanaleigenschaften an die eingangs genannten Anforderungen anpassen lassen. Das resultierende Dotierungsprofil des Kanalgebiets weist somit im zweiten Abschnitt ein erstes Maximum der Nettokonzentration auf und geht nachfolgend im ersten Abschnitt in eine vergleichsweise konstante und gegenüber dem ersten Maximum geringere Nettokonzentration über.

Durch den zweiten und im wesentlichen höher dotierten Abschnitt wird die Einsatzspannung U_{T} unabhängig von einer möglichen Kanalgeometrie bestimmt. Weiterhin werden die sich zwischen dem ersten Dotierungsgebiet und dem Kanalgebiet sowie zwischen dem zweiten Dotierungsgebiet und dem Kanalgebiet herausbildenden Verarmungszonen durch den höher dotierten zweiten Abschnitt des Kanalgebiets stärker voneinander getrennt. Somit wird ein Übergreifen bzw. ein Verschmelzen dieser Verarmungszonen weitestgehend vermieden und damit auch der sogenannte Punchthrough-Effekt. Im Gegensatz zum zweiten Abschnitt ist der schwächer dotierte erste Abschnitt des Kanalgebiets für die Aufrechterhaltung der Spannungsfestigkeit und einer hohen Gatesteilheit verantwortlich.

Der zweite und höher dotierte Abschnitt des Kanalgebiets weist in Abhängigkeit von seiner Ausdehnung entlang der Erstreckung zwischen dem ersten und zweiten Dotierungsgebiet eine derart hohe Nettokonzentration des Dotierstoffs auf, daß die Einsatzspannung in einem bevorzugten Bereich von 0,3 bis 0,6 V liegt. Selbstverständlich ist auch jede beliebige andere Einsatzspannung durch Veränderung der Nettokonzentration des Dotierstoffs einstellbar.

Die Nettokonzentration des Dotierstoffs im stärker dotierten zweiten Abschnitt ist mindestens doppelt so hoch wie im schwächer dotierten ersten Abschnitt.

Eine weitere vorteilhafte Ausführungsform der Erfindung ist dadurch gekennzeichnet, daß die Nettokonzentration im zweiten Abschnitt mindestens zehn mal höher als im ersten Abschnitt ist.

Besonders vorteilhaft ist ein Nettokonzentrationsunterschied zwischen den beiden Abschnitten im Bereich einer Größenordnung. Der schwächer dotierte erste Abschnitt soll dabei eine nicht zu hohe Nettokonzentration des Dotierstoffs aufweisen, da dieser Abschnitt durch eine hohe Beweglichkeit der Ladungsträger gekennzeichnet ist. Der zweite Abschnitt dagegen weist eine etwa zehn mal so hohe Nettokonzentration wie der erste Abschnitt auf. Grundsätzlich kann der Nettokonzentrationsunterschied auch um einen Faktor größer als zehn variieren.

Eine weitere vorteilhafte Ausführungsform der Erfindung ist dadurch gekennzeichnet, daß der erste Abschnitt und der zweite Abschnitt durch aufeinanderfolgende Prozeßschritte geschaffen sind.

Die beiden Abschnitte des Kanalgebiets werden nacheinander in unterschiedlichen Prozeßschritten gebildet, wobei je nach Ausgestaltung des erfindungsgemäßen Halbleiterbauelements zuerst der erste Abschnitt, gefolgt vom zweiten Abschnitt, oder umgekehrt geschaffen wird. Auch müssen die jeweiligen Prozeßschritte nicht notwendigerweise unmittelbar aufeinander folgen. Vorteilhaft ist, daß sich durch die unterschiedlichen Prozeßschritte die Eigenschaften der Abschnitte unabhängig voneinander einstellen lassen. Unterschiedliche Prozesse sind beispielsweise unterschiedlich starke Ionenimplantationen.

Eine weitere vorteilhafte Ausführungsform der Erfindung ist dadurch gekennzeichnet, daß in Erstreckung zwischen dem ersten und dem zweiten Dotierungsgebiet die Breite des zweiten Abschnitts geringer als die Breite des ersten Abschnitts ist.

Durch eine größere Ausdehnung des ersten Abschnitts in Erstreckungsrichtung gegenüber dem zweiten Abschnitt werden in vorteilhafter Weise die Kanaleigenschaften, insbesondere die Spannungsfestigkeit, die Gatesteilheit sowie die Subthreshold-Steilheit verbessert.

Eine weitere vorteilhafte Ausführungsform der Erfindung ist dadurch gekennzeichnet, daß die Lage des zweiten Abschnitts unmittelbar angrenzend an das erste oder zweite Dotierungsgebiet ist.

Hierdurch werden die jeweiligen Verarmungszonen zwischen dem ersten Dotierungsgebiet und dem Kanalgebiet sowie zwischen dem zweiten Dotierungsgebiet und dem Kanalgebiet in ausreichendem Maße voneinander getrennt.

Eine weitere vorteilhafte Ausführungsform der Erfindung ist dadurch gekennzeichnet, daß der zweite Abschnitt zwischen dem ersten Abschnitt und einem schwach dotierten dritten Abschnitt des Kanalgebiets angeordnet ist.

Bei dieser Ausführungsform ist der stärker dotierte zweite Abschnitt von zwei schwächer dotierten Abschnitten gleichen Leitungstyps begrenzt. Die beiden angrenzenden ersten und dritten Abschnitte können eine gleiche, aber auch eine unterschiedlich hohe Nettokonzentration des Dotierstoffs je nach Art der Optimierung an die geforderten Kanaleigenschaften aufweisen. Selbstverständlich können die ersten und dritten Abschnitte durch ein den ersten Leitungstyp aufweisendes Grundsubstrat gebildet sein, in das durch beispielsweise Ionenimplantation der zweite Abschnitt eingebracht wird. Der zweite Abschnitt weist somit gegenüber dem ersten und dritten Abschnitt eine deutlich höhere Nettokonzentration des Dotierstoffs und damit eine höhere Leitfähigkeit auf.

Eine vorteilhafte Ausführungsform der Erfindung ist dadurch gekennzeichnet, daß das erste und zweite Dotierungsgebiet sowie das Kanalgebiet mit seinen Abschnitten in einem gemeinsamen Substrat liegen.

Durch Einbringen des ersten und zweiten Dotierungsgebiets sowie des Kanalgebiets in einem gemeinsamen Substrat kann in einfacher Art und Weise ein planarer MOSFET hergestellt werden.

Eine weitere vorteilhafte Ausführungsform der Erfindung ist dadurch gekennzeichnet, daß das erste und zweite Dotierungsgebiet sowie das Kanalgebiet mit seinen Abschnitten in Stapelform auf einem Substrat aufgebracht sind.

Durch geeignete z. B. epitaktische Abscheidungsprozesse auf einem Substrat können nacheinander das erste Dotierungsgebiet, das Kanalgebiet und schließlich das zweite Dotierungsgebiet geschaffen werden, wodurch sogenannte vertikale MOSFET's entstehen. Bei der epitaktischen Auftragung des Kanalgebiets wird dieses in geeigneter Weise mit unterschiedlich stark dotierten Abschnitten versehen.

Eine weitere vorteilhafte Ausführungsform der Erfindung ist dadurch gekennzeichnet, daß die Abschnitte des Kanalgebiets durch Epitaxieschichten mit unterschiedlich hoher Nettokonzentration des Dotierstoffs gebildet sind.

Durch aufeinanderfolgende epitaktische Auftragung von zwei oder mehreren unterschiedlich stark dotierten Abschnitten wird das Kanalgebiet in einfacher Art und Weise geschaffen. Die einzelnen Abschnitte können entweder jeweils mit dem gleichen jedoch in unterschiedlich hoher Konzentration vorliegenden Dotierstoffen versehen sein, aber auch unterschiedliche Dotierstoffe aufweisen. Grundsätzlich weisen die einzelnen Abschnitte des Kanalgebiets jedoch den ersten Leitungstyp auf.

Vorteilhaft ist das Halbleiterbauelement ein MOS-Transistor.

Ein Verfahren zur Herstellung eines erfindungsgemäßen Halbleiterbauelements ist gekennzeichnet durch folgende Schritte:
- Bereitstellen des mit einem Dotierstoff vom ersten Leitungstyp dotierten Substrats;
- Ausbilden der Elektrode auf diesem Substrat;
- Abdecken eines auf einer Seite der Elektrode liegenden ersten Bereichs des Substrats mit einer Maske;
- Ausbilden des stärker dotierten Abschnitts durch Einbringen eines Dotierstoffs vom ersten Leitungstyp in einen zweiten Bereich des Substrats, der auf einer anderen Seite der Elektrode angeordnet und nicht von der Maske abgedeckt ist;
- Entfernen der Maske; und
- Einbringen eines Dotierstoffs vom zweiten Leitungstyp in den ersten und zweiten Bereich des Substrats auf beiden Seiten der Elektrode, wodurch das erste und zweite Dotierungsgebiet und zwischen diesen der schwächer dotierte und vom Substrat gebildete Abschnitt geschaffen werden.

Zunächst wird auf einem Substrat, das beispielsweise den ersten Leitungstyp aufweist, die Elektrode unter Zwischenlage einer isolierenden Schicht aufgebracht. Die Elektrode sowie die isolierende Schicht lassen sich in geeigneter Weise, zum Beispiel lithographisch, strukturieren. Anschließend wird eine Seite der Elektrode und ein an die Elektrode angrenzender erster Bereich des Substrats mit einer Maske abgedeckt. Es folgt ein Einbringen des Dotierstoffs in den nicht durch die Maske abgedeckten zweiten Bereich des Substrats, wodurch ein stärker dotierter Abschnitt des Kanalgebiets geschaffen wird. Dabei kann gleichzeitig die Elektrode, die beispielsweise aus polykristallinem Silizium gebildet ist, in geeigneter Weise dotiert werden. Nach dem Einbringen des Dotierstoffs in das Substrat wird die Maske entfernt und ein Dotierstoff in den ersten und zweiten Bereich des Substrats eingearbeitet. Hierdurch werden die beiden Dotierungsgebiete vom zweiten Leitungstyp geschaffen. Das Kanalgebiet erstreckt sich nun unterhalb der Elektrode zwischen dem ersten Dotierungsgebiet und dem zweiten Dotierungsgebiet. Auf einer Seite des Kanalgebiets und beispielsweise an das erste Dotierungsgebiet angrenzend ist ein durch Einbringen des Dotierstoffs geschaffener Abschnitt mit einer hohen Konzentration des Dotierstoffs angeordnet. Der schwächer dotierte Abschnitt des Kanalgebiets wird durch das den ersten Leitungstyp aufweisende Substratmaterial gebildet.

Eine vorteilhafte Ausführungsform des erfindungsgemäßen Verfahrens ist dadurch gekennzeichnet, daß der Dotierstoff vom ersten Leitungstyp auf der anderen Seite der Elektrode durch Implantation, vorzugsweise unter einem schrägen Winkel in Richtung unter die Elektrode, in das Substrat eingebracht wird.

Durch Implantation des Dotierstoffs unter einem schrägen Winkel läßt sich das Kanalgebiet unterhalb der Elektrode besser strukturieren.

Eine weitere Ausführungsform des erfindungsgemäßen Herstellungsverfahrens ist dadurch gekennzeichnet, daß der Dotierstoff vom ersten Leitungstyp durch thermische Diffusion unter die Elektrode in das Substrat getrieben wird.

Eine bessere Strukturierung des Kanalgebiets und damit Schaffung der einzelnen Abschnitte mit unterschiedlich hoher Dotierstoffkonzentration ist ebenfalls durch eine thermische Diffusion des Dotierstoffs in das Substrat möglich.

Ein weiteres Verfahren zur Herstellung des erfindungsgemäßen Halbleiterbauelements ist durch folgende Schritte gekennzeichnet:
- Bereitstellen des mit einem Dotierstoff vom ersten Leitungstyp dotierten Substrats;
- Ausbilden der Elektrode über dem Kanalgebiet durch die Schritte:
   - Aufwachsen eines Gateoxids;
   - selektives Aufoxidieren des Gateoxids in einem Bereich;
   - Ausbilden eines Spacers auf einer Seite des aufoxidierten Bereichs als Elektrode;
- Ausbilden des stärker dotierten Abschnitts durch Einbringen eines Dotierstoffs vom ersten Leitungstyp auf der dem aufoxidierten Bereich abgewandten Seite der Elektrode;
- Entfernen des aufoxidierten Bereichs; und
- Einbringen eines Dotierstoffs des zweiten Leitungstyps auf beiden Seiten der Elektrode, wodurch das erste und zweite Dotierungsgebiet und zwischen diesen der schwächer dotierte und vom Substrat gebildete Abschnitt geschaffen werden.

Auf einem den ersten Leitungstyp aufweisenden Substratmaterial wird ein sogenanntes Gateoxid abgeschieden. Anschließend wird das Gateoxid in einem vorgegebenen Bereich aufoxidiert, so daß Teile des Gateoxids mit einer aufoxidierten Schicht versehen sind. Diese Schicht, beispielsweise Siliziumdioxid, sowie das nicht aufoxidierte Gateoxid werden mit einer weiteren Schicht, beispielsweise Polysilizium, überzogen. Durch beispielsweise anisotropes und selektives Ätzen wird die weitere Schicht soweit strukturiert, daß nur einzelne Bereiche, sogenannte Spacer, am Übergangsbereich zwischen der aufoxidierten Schicht und dem Gateoxid übrigbleiben. Nachfolgend wird ein Dotierstoff, beispielsweise Bor, selbstjustierend in das Substrat implantiert. Hierdurch wird der stärker dotierte Abschnitt des Kanalgebiets geschaffen. Anschließend wird die aufoxidierte Schicht vollständig entfernt, das Gateoxid strukturiert und die beiden Dotierungsgebiete seitlich neben dem Spacer durch Implantation geschaffen. Der Spacer kann nachfolgend als Elektrode verwendet werden.

Ein weiteres Verfahren zur Herstellung eines erfindungsgemäßen Halbleiterbauelements ist gekennzeichnet durch folgende Schritte:
- Bereitstellen des Substrats;
- epitaktisches Abscheiden in Stapelform auf dem Substrat
   - des zweiten Dotierungsgebiets;
   - des schwächer dotierten Abschnitts und des stärker dotierten Abschnitts auf das bereits abgeschiedene zweite Dotierungsgebiet, wodurch das Kanalgebiet geschaffen wird;
   - und des ersten Dotierungsgebiets auf dem abgeschiedenen stärker dotierten Abschnitt;
- Vorsehen der Elektrode unter Zwischenlage des Gateoxids (65) seitlich des Stapels.

Mit diesem Verfahren werden mittels epitaktischer Abscheidung auf einem Grundsubstrat sogenannte vertikale Kurzkanaltransistoren hergestellt. Dabei werden zunächst das erste Dotierungsgebiet, gefolgt von dem Kanalgebiet und schließlich von dem zweiten Dotierungsgebiet, nacheinander auf dem Substrat abgeschieden, wobei die Abschnitte des Kanalgebiet jeweils durch einzelne Epitaxieschichten mit unterschiedlich hoher Konzentration des Dotierstoffs gebildet werden. Durch geeignete Strukturierung dieser Schichten entsteht senkrecht zu den einzelnen Schichten eine gemeinsame Stirnfläche, an der unter Zwischenlage eines isolierenden Oxids die Elektrode geschaffen wird.

Ausführungsbeispiele der Erfindung sind in den Zeichnungen dargestellt und nachfolgend näher erläutert.

Es zeigt:
- Fig. 1: eine schematische Darstellung eines Halbleiterbauelements als erste Ausführungsform der vorliegenden Erfindung;
- Fig. 2: eine Auftragung der Dotierstoffkonzentration entlang des Kanalgebiets für das Halbleiterbauelement nach Fig. 1;
- Fig. 3: eine schematische Darstellung eines Halbleiterbauelements als zweite Ausführungsform der vorliegenden Erfindung;
- Fig. 4: eine schematische Darstellung eines Halbleiterbauelements als dritte Ausführungsform der vorliegenden Erfindung;
- Fig. 5: eine schematische Darstellung zur Herstellung des Halbleiterbauelements nach Fig. 1 gemäß einer ersten Verfahrensvariante; und
- Fig. 6: eine schematische Darstellung zur Herstellung des Halbleiterbauelements nach Fig. 1 gemäß einer zweiten Verfahrensvariante.

In den Figuren bezeichnen gleiche Bezugszeichen gleiche oder funktionsgleiche Bestandteile.

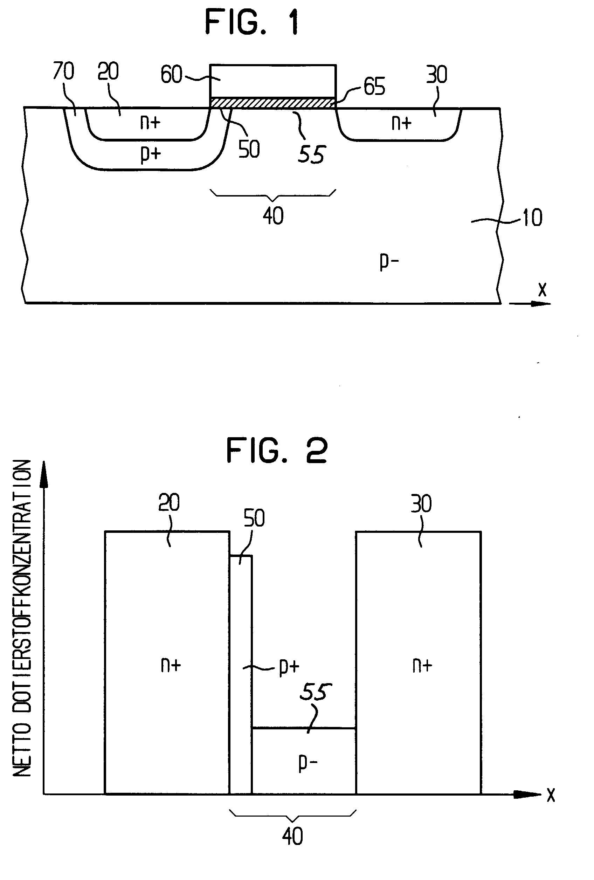

Fig. 1 ist eine schematische Darstellung eines Halbleiterbauelements in Form eines n-Kanal-MOSFET als erste Ausführungsform der vorliegenden Erfindung.

In Figur 1 bezeichnet 10 ein p⁻ -Substrat, 20 ein erstes n⁺-Dotierungsgebiet (Source), 30 ein zweites n⁺-Dotierungsgebiet (Drain), 40 ein Kanalgebiet, 50 einen Abschnitt vom Kanalgebiet 40, 60 ein als Elektrode dienendes Gate über einem Gateoxid 65 und 70 ein Dotierungsgebiet zur Aufdotierung des Abschnitts 50 des Kanalgebiets 40 zum Erreichen einer inhomogenen Dotierung entlang des Kanalgebiets 40.

In lateraler Erstreckung schließt sich an das erste Dotierungsgebiet 20 der zweite Abschnitt 50 des Kanalgebiets 40 an, das seinerseits mit dem ersten Abschnitt 55 an das zweite Dotierungsgebiet angrenzt. Der erste Abschnitt 55 weist die gleiche Dotierung wie das Grundsubstrat auf. Im Gegensatz dazu wurde der zweite Abschnitt 50 durch zusätzliches Einbringen eines Dotierstoffs geschaffen, so daß der zweite Abschnitt eine hohe Nettokonzentration des Dotierstoffs aufweist. Beide Abschnitte 50 und 55 sind jedoch vom gleichen Leitungstyp und erstrecken sich im wesentlichen unterhalb des Gates 60 und des Gateoxids 65.

Die asymmetrische Dotierung p⁺ im an das Sourcegebiet 20 angrenzenden zweiten Abschnitt 50 des Kanalgebietes 40 garantiert eine definierte Einsatzspannung während das p⁻-Gebiet mit der Dotierstoffkonzentration des Substrats 10, das den ersten Abschnitt 55 bildet, die Spannungsfestigkeit, die Reduktion des DIBL (Drain Induced Barrier Lowering), eine hohe Beweglichkeit usw. gewährleistet (vergleiche obige Anforderungsliste).

Das gleiche Prinzip kann selbstverständlich auch für p-Kanal-MOSFET's angewendet werden, d.h. bei MOSFET's, bei denen die Leitungstypen der Dotierungsgebiete und des Kanalgebiets miteinander vertauscht sind.

Fig. 2 ist eine Auftragung der Nettokonzentration des Dotierstoffs entlang des Kanalgebiets 40 und der Dotierungsgebiete (20, 30) für das Halbleiterbauelement nach Fig. 1. Deutlich erkennbar ist die inhomogene Dotierung des Kanalgebiets 40 durch die 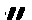 Dotierungsspitze" 50.

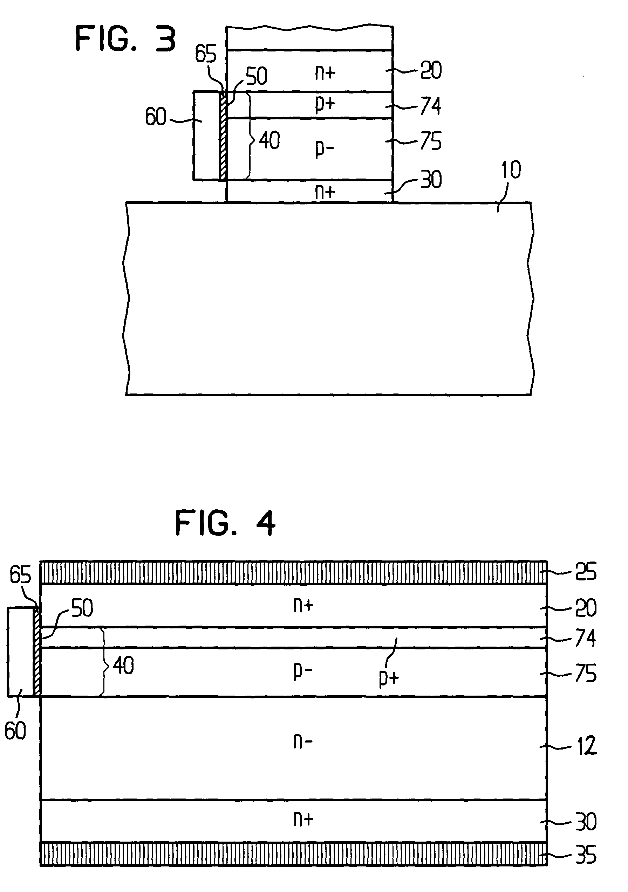

Fig. 3 ist eine schematische Darstellung eines Halbleiterbauelements in Form eines n-Kanal-MOSFET als zweite Ausführungsform der vorliegenden Erfindung.

Bei der in Figur 3 gezeigten zweiten Ausführungsform sind das erste und zweite n⁺-Dotierungsgebiet 20, 30 sowie das Kanalgebiet 40, welches durch die beiden Schichten 74 und 75 gebildet ist, nicht in das Substrat 10 eingebracht, sondern liegen epitaktisch in Stapelform auf dem Substrat 10 vor. Das über dem Kanalgebiet 40 vorgesehene Gate 60 mit dem Gateoxid 65 liegt seitlich dieses Stapels. Das inhomogene Dotierungsprofil des Kanalgebiets 40 ist durch die unterschiedlichen Konzentrationen des Dotierstoffs in den beiden Epitaxieschichten 74 (p⁺) und 75 (p⁻) gebildet.

In diesem Zusammenhang sei auch erwähnt, daß der Abschnitt 50 mit der wesentlich größeren Dotierstoffkonzentration in der Epitaxieschicht 74 nicht unbedingt direkt an das erste n⁺-Dotierungsgebiet 20 angrenzen muß, sondern z.B. auch beidseitig von p⁻-Gebieten eingebettet, also von schwächer dotierten Abschnitten, vorgesehen werden kann.

Fig. 4 ist eine schematische Darstellung eines Halbleiterbauelements in Form eines vertikalen p-Kanal-Leistungs-MOSFET als dritte Ausführungsform der vorliegenden Erfindung.

Simulationen zeigen, daß das erfindungsgemäße Prinzip auch für vertikale Leistungs-MOSFET's Vorteile bezüglich Rₒₙ bringt. Zusätzlich können Rₒₙ und die Einsatzspannung U_{T} unabhängig voneinander eingestellt werden. Dieses Prinzip liefert nämlich ein Electric Field Tailoring für Kurzkanal-MOSFET's, das durch Simulationen und Messungen an Bauelementen verifiziert wurde.

In Figur 4 bezeichnet 10 ein n⁻-Substrat, und 25 und 35 jeweilige Kontaktierungen des ersten n⁺-Dotierungsgebiets 20 bzw. des zweiten n⁺-Dotierungsgebiets 30. Der Kanalbereich 40 verläuft bei der in Figur 4 gezeigten Ausführungsform vertikal auf der linken Seite unter der Gatestruktur 60, 65.

Zwischen dem schwach dotierten ersten Abschnitt 75 und dem zweiten Dotierungsgebiet 30 ist zusätzlich ein durch das Substrat 12 gebildetes schwach dotiertes Draingebiet (LDD) 12 ausgebildet. Dieses schwach dotierte Draingebiet 12 dient insbesondere zur Verhinderung von sogenannten 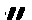 heißen" Elektronen, die bei hohen Feldstärkespitzen auftreten können und z. B. zu einer lokalen Aufladung des Gateoxids 65 führen können.

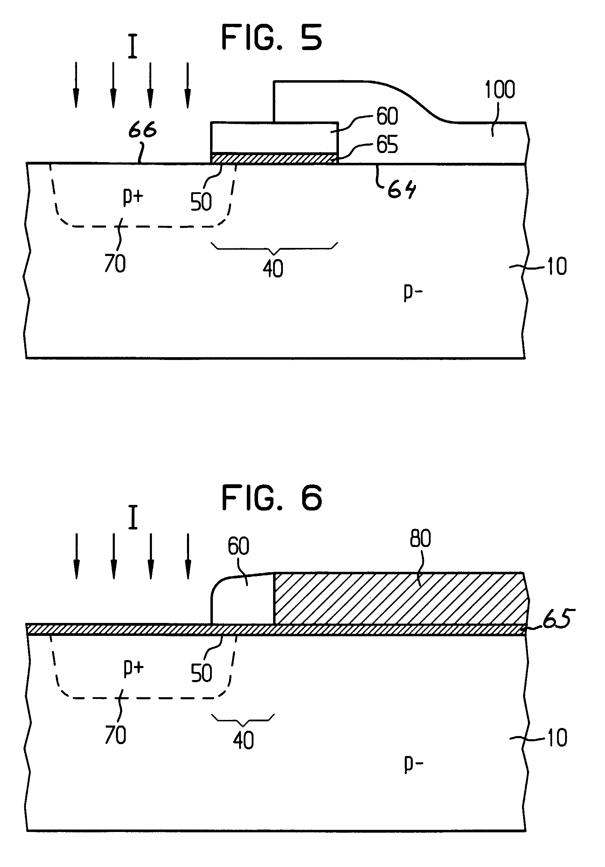

Figur 5 ist eine schematische Darstellung zur Herstellung des Halbleiterbauelements nach Figur 1 gemäß einer ersten Verfahrensvariante.

Es wird zunächst ein p⁻-Substrat 10 bereitgestellt. Darauf erfolgt ein Ausbilden der Gatestruktur mit dem Gate 60, das über dem Gateoxid 65 liegt, über dem Kanalgebiet 40.

Mit einer Maske 100, wie z.B. einer Hartmaske, wird eine Seite des Gates 60 sowie ein an das Gate 60 angrenzender erster Bereich 64 des Substrats 10 abgedeckt, und danach wird ein p-Dotierstoff, wie z.B. Bor, auf der anderen Seite des Gates 60 in einen nicht von der Maske 100 abgedeckten Bereich 66 des Substrats 10 implantiert (Pfeile I).

Bor beispielsweise hat bei der Implantation eine hohe laterale Standardabweichung und wird unter das Gateoxid 65 gestreut. Durch schräge Implantation kann dieser Effekt verstärkt werden, d.h. zweckmäßigerweise wird der p-Dotierstoff durch Implantation unter einem schrägen Winkel in Richtung unter das Gate 60 und das Gateoxid 65 eingebracht. Der p-Dotierstoff kann danach durch thermische Diffusion weiter unter das Gateoxid 65 getrieben werden. Durch diese Implantation in den zweiten Bereich 66 wird der zweite Abschnitt 50 geschaffen.

Nach Entfernen der Maske 100 erfolgt das Einbringen eines n-Dotierstoffs, wie z.B. Phosphor, auf beiden Seiten des Gate 60, um Source und Drain, also das erste und zweite Dotierungsgebiet 20, 30, auszubilden.

Figur 6 ist eine schematische Darstellung zur Herstellung des Halbleiterbauelements nach Figur 1 gemäß einer zweiten Verfahrensvariante.

Es wird zunächst ein p⁻-Substrat 10 bereitgestellt. Darauf erfolgt das Ausbilden der Gatestruktur mit dem Gate 60, das über dem Gateoxid 65 liegt, über dem Kanalgebiet 40 in anderer Weise als bei der ersten Verfahrensvariante.

Es erfolgt zunächst das Aufwachsen eines Gateoxids 65, gefolgt durch selektives Aufoxidieren des Gateoxids 65 in einem Bereich 80.

Dann wird ein Spacer 60 auf einer Seite des aufoxidierten Bereichs 80 als Gate 60 nach üblicher Art und Weise geschaffen. Hierbei wird zunächst Polysilizium auf dem Gateoxid 65 und dem aufoxidierten Bereich 80 abgeschieden, gefolgt von einem selektiven und anisotropen Ätzvorgang bezüglich Polysilizium, wodurch nur ein sich unmittelbar an den aufoxidierten Bereich 80 anschließender Spacer 60 gebildet verbleibt.

Ein p-Dotierstoff, wie z.B. Bor, wird auf der dem aufoxidierten Bereich 80 abgewandten Seite des Gates 60 implantiert (Pfeile I). Zweckmäßigerweise wird wie oben der p-Dotierstoff durch Implantation unter einem schrägen Winkel in Richtung unter das Gateoxid 65 eingebracht. Der p-Dotierstoff kann danach durch thermische Diffusion weiter unter das Gateoxid 65 getrieben werden.

Nach Entfernen des aufoxidierten Bereichs 80 erfolgt das Einbringen eines n-Dotierstoffs, wie z.B. Phosphor, auf beiden Seiten des Gates 60, um Source und Drain, also das erste und zweite Dotierungsgebiet 20, 30, auszubilden.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Insbesondere kann die räumliche Modulation des Dotierungsprofils des Kanalgebiet 40 entlang seiner Erstreckung zwischen dem ersten und dem zweiten Dotierungsgebiet 20, 30 den jeweiligen Anforderungen entsprechend gestaltet werden und ist nicht auf die gezeigte 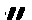 Spitzenmodulation" beschränkt. Insbesondere kann das Kanalgebiet 40 auch durch drei aneinander angrenzende Abschnitte gebildet werden, wobei der mittlere Abschnitt gegenüber den beiden äußeren Abschnitten eine höhere Nettokonzentration des Dotierstoffs aufweist.

Auch kann das erfindungsgemäße Halbleiterbauelement Teil einer Thyristorstruktur oder einer sonstigen komplizierteren Bauelementstruktur sein.

LDD-Gebiete, also Gebiete mit geringer Dotierstoffkonzentration, die zwischen dem Kanalgebiet 40 und den Dotierungsgebieten 20 und 30 angeordnet sind und den gleichen Leitungstyp wie die Dotierungsgebiete 20 und 30 aufweisen, können selbstverständlich bei Bedarf zusätzlich vorgesehen werden, sind aber in vielen Fällen nicht notwendig.

Obwohl bei der obigen Ausführungsform zunächst das Aufwachsen eines Gateoxids 65 gefolgt durch selektives Aufoxidieren des Gateoxids im Bereich 80 erfolgt, ist es möglich und technologisch sogar einfacher, zunächst ein dickes Oxid ganzflächig durch thermische Oxidation zu schaffen, dieses anschließend zu strukturieren und danach das Gateoxid vorzusehen.

## Patentansprüche

1. Halbleiterbauelement:
- mit einem Kanalgebiet (40), das mit einem Dotierstoff dotiert ist, das einen ersten Leitungstyp aufweist und das sich zwischen einem ersten Dotierungsgebiet (20) und einem vom ersten Dotierungsgebiet (20) beabstandeten zweiten Dotierungsgebiet (30) erstreckt, wobei das erste und zweite Dotierungsgebiet (20, 30) einen zweiten Leitungstyp aufweisen, und
- mit einer am Kanalgebiet (40) vorgesehenen und gegenüber diesem isolierten Elektrode (60),
**dadurch gekennzeichnet** daß
das Kanalgebiet (40) entlang seiner Erstreckung zwischen dem ersten und zweiten Dotierungsgebiet (20, 30) zumindest zwei Abschnitte (50, 55) mit unterschiedlich hoher Nettokonzentration des Dotierstoffs aufweist.

2. Halbleiterbauelement nach Anspruch 1,
**dadurch gekennzeichnet,** daß
das Kanalgebiet (40) entlang seiner Erstreckung zwischen dem ersten und zweiten Dotierungsgebiet (20, 30) einen schwach dotierten ersten Abschnitt (55) mit einer geringen Leitfähigkeit und einen gegenüber diesem stärker dotierten zweiten Abschnitt (50) mit einer hohen Leitfähigkeit aufweist.

3. Halbleiterbauelement nach Anspruch 2,
**dadurch gekennzeichnet,** daß
die Nettokonzentration im zweiten Abschnitt (55) mindestens zehn mal höher als im ersten Abschnitt (50) ist.

4. Halbleiterbauelement nach Anspruch 2 oder 3,
**dadurch gekennzeichnet,** daß
der erste Abschnitt (55) und der zweite Abschnitt (50) durch aufeinanderfolgende Prozeßschritte geschaffen sind.

5. Halbleiterbauelement nach einem der Ansprüche 2 bis 4,
**dadurch gekennzeichnet,** daß
in Erstreckung zwischen dem ersten und dem zweiten Dotierungsgebiet (20, 30) die Breite des zweiten Abschnitts (50) geringer als die Breite des ersten Abschnitts (55) ist.

6. Halbleiterbauelement nach einem der Ansprüche 2 bis 5,
**dadurch gekennzeichnet,** daß
die Lage des zweiten Abschnitts (50) unmittelbar angrenzend an das erste oder zweite Dotierungsgebiet (20, 30) ist.

7. Halbleiterbauelement nach einem der Ansprüche 2 bis 6,
**dadurch gekennzeichnet,** daß
der zweite Abschnitt (50) zwischen dem ersten Abschnitt (55) und einem schwach dotierten dritten Abschnitt des Kanalgebiets (40) angeordnet ist.

8. Halbleiterbauelement nach einem der vorhergehenden Ansprüche,
**dadurch gekennzeichnet,** daß
das erste und zweite Dotierungsgebiet (20, 30) sowie das Kanalgebiet (40) mit seinen Abschnitten (50, 55) in einem gemeinsamen Substrat (10) liegen.

9. Halbleiterbauelement nach einem der vorhergehenden Ansprüche,
**dadurch gekennzeichnet,** daß
das erste und zweite Dotierungsgebiet (20, 30) sowie das Kanalgebiet (40) mit seinen Abschnitten (50, 55) in Stapelform auf einem Substrat (10) aufgebracht sind.

10. Halbleiterbauelement nach Anspruch 9,
**dadurch gekennzeichnet,** daß
die Abschnitte (50, 55) des Kanalgebiets (40) durch Epitaxieschichten mit unterschiedlich hoher Nettokonzentration des Dotierstoffs gebildet sind.

11. Verfahren zur Herstellung des Halbleiterbauelements nach einem der Ansprüche 1 bis 8 mit den Schritten:
- Bereitstellen des mit einem Dotierstoff vom ersten Leitungstyp dotierten Substrats (10);
- Ausbilden der Elektrode (60) auf diesem Substrat (10);
- Abdecken eines auf einer Seite der Elektrode (60) liegenden ersten Bereichs (64) des Substrats (10) mit einer Maske (100);
- Ausbilden des stärker dotierten Abschnitts (50) durch Einbringen eines Dotierstoffs vom ersten Leitungstyp in einen zweiten Bereich (66) des Substrats (10), der auf einer anderen Seite der Elektrode (60) angeordnet und nicht von der Maske (100) abgedeckt ist;
- Entfernen der Maske (100); und
- Einbringen eines Dotierstoffs vom zweiten Leitungstyp in den ersten und zweiten Bereich (64, 66) des Substrats (10) auf beiden Seiten der Elektrode (60), wodurch das erste und zweite Dotierungsgebiet (20, 30) und zwischen diesen der schwächer dotierte und vom Substrat (10) gebildete Abschnitt (55) geschaffen werden.

12. Verfahren nach Anspruch 11,
**dadurch gekennzeichnet,** daß
der Dotierstoff vom ersten Leitungstyp auf der anderen Seite der Elektrode (60) durch Implantation, vorzugsweise unter einem schrägen Winkel in Richtung unter die Elektrode (60), in das Substrat (10) eingebracht wird.

13. Verfahren nach Anspruch 11 oder 12,
**dadurch gekennzeichnet,** daß
der Dotierstoff vom ersten Leitungstyp durch thermische Diffusion unter die Elektrode (60) in das Substrat (10) getrieben wird.

14. Verfahren zur Herstellung des Halbleiterbauelements nach einem der Ansprüche 1 bis 8 mit den Schritten:
- Bereitstellen des mit einem Dotierstoff vom ersten Leitungstyp dotierten Substrats (10);
- Ausbilden der Elektrode (60) über dem Kanalgebiet (40) durch die Schritte:
- Aufwachsen eines Gateoxids (65);
- selektives Aufoxidieren des Gateoxids (65) in einem Bereich (80);
- Ausbilden eines Spacers (60) auf einer Seite des aufoxidierten Bereichs (80) als Elektrode (60);
- Ausbilden des stärker dotierten Abschnitts (50) durch Einbringen eines Dotierstoffs vom ersten Leitungstyp auf der dem aufoxidierten Bereich (80) abgewandten Seite der Elektrode (60);
- Entfernen des aufoxidierten Bereichs (80); und
- Einbringen eines Dotierstoffs des zweiten Leitungstyps auf beiden Seiten der Elektrode (60), wodurch das erste und zweite Dotierungsgebiet (20, 30) und zwischen diesen der schwächer dotierte und vom Substrat (10) gebildete Abschnitt (55) geschaffen werden.

15. Verfahren zur Herstellung des Halbleiterbauelements nach Anspruch 9 oder 10 mit den Schritten:
- Bereitstellen des Substrats (10);
- epitaktisches Abscheiden in Stapelform auf dem Substrat (10)
- des zweiten Dotierungsgebiets (30);
- des schwächer dotierten Abschnitts (75) und des stärker dotierten Abschnitts (74) auf das bereits abgeschiedene zweite Dotierungsgebiet (30), wodurch das Kanalgebiet (40) geschaffen wird;
- und des ersten Dotierungsgebiets (20) auf dem abgeschiedenen stärker dotierten Abschnitt (74);
- Vorsehen der Elektrode (60) unter Zwischenlage des Gateoxids (65) seitlich des Stapels.
